# EUROPEAN PATENT APPLICATION

(11) **EP 1 505 729 A2**
(43) Date of publication of application: **09.02.2005**
(21) Application number: 04018721.3
(22) Date of filing: 06.08.2004
(51) Int. Cl.: H03H 9/05

(54) **Conductive adhesive and piezoelectric device using it**

(30) Priority: 07.08.2003 JP 2003289345
(71) Applicant: Seiko Epson Corporation, Shinjuku-ku, Tokyo 163-0811 (JP)
(72) Inventor: Iguchi, Shuichi c/o SEIKO EPSON CORPORATION, Suwa-shi, Nagano-ken 392-8502 (JP)
(74) Representative: Hoffmann, Eckart, Dipl.-Ing.

(57) **Abstract**

In an SAW device in which an SAW element (5) is mounted on a base (1) of a package (4) with its bonding pads (10) and connection terminals (11) of the package connected by bonding wires, a lid (2) is joined to the base (1) by seam welding to be hermetically sealed. The SAW element (5) is bonded and affixed to a mounting surface (6) of the base (1) by using a conductive adhesive (7) which contains 80 to 85 wt.% of a resin material and 20 to 15 wt.% of a flaky conductive filler, or a conductive adhesive which contains an 82.5 to 85 wt.% of a resin material and 17.5 to 15 wt.% of a conductive filler, the conductive filler comprising 30 wt.% of a small particulate conductive filler and 70 wt.% of a large particulate conductive filler.

## Description

This invention relates to a conductive adhesive suited for a structure of a piezoelectric device, for example, with a piezoelectric element such as an SAW (surface acoustic wave) device bonded and affixed to inside a package. The invention also relates to a piezoelectric device using the conductive adhesive for bonding its piezoelectric element.

Conventionally, equipped with an IDT (interdigital transducer) consisting of interdigital electrodes formed on a surface of a piezoelectric substrate and a reflector, SAW devices such as resonators, filters, oscillators and the like utilizing an SAW element which uses an elastic surface wave as excited by an IDT are widely used for a variety of electronic apparatus and equipment. Particularly, in recent years, high frequency and high precision SAW devices capable of meeting high-speed requirements of communications are in demand in fields of communications equipment and the like.

Typically, the SAW device has a package in which a metallic lid is hermetically joined and sealed by seam welding, via a seal ring, to an upper end of a base made up of a ceramic material, and an SAW element is mounted therein. The SAW element has its lower surface bonded and affixed with an adhesive to an empty bottom surface on the base, while each bonding pad for electrode connection provided on an upper surface thereof is electrically connected to a corresponding connection terminal in the package through a bonding wire. For this, there is typically used a bonding wire of an aluminum type material, and its tip is joined to a bonding pad surface by a wedge bonding method that performs joining by applying ultrasonic vibration while pressurizing with a wedge tool as disclosed in JP-A-2003-110401, for example.

The metallic lid reaches a high temperature of approx. 200 to 500°C due to heat generated at the time of seam welding, hence, fused joining of it is carried out in a thermally expanded state more than that of the ceramic base that has a small thermal expansion rate. When the structure then returns to the normal temperature after hermetic sealing, the lid contracts more than the base. Consequently, stress is generated in the base such as to deform it downward convex. This deformation is conveyed to the SAW element through the adhesive, possibly affecting its characteristics adversely. Although the adhesive somewhat contracts when it is baked and hardened, stress due to this will also act on the SAW element. These stresses are not desirable in terms of achieving high frequency and high precision.

There have been proposed SAW devices, one having a structure in which an SAW element is bonded and affixed to only the central part of the base of a package or bonded and affixed by an elastic adhesive or through a buffer material, and another one having a structure in which a silicon resin layer is formed on the bottom surface of a cavity of a package and an SAW element is bonded and affixed thereon by using an elastic adhesive so as to absorb stress such as thermal distortion due to seam welding (JP-A-6-177701 and JP-A-2002-16476).

To attain high frequency and high precision of SAW devices, an adhesive for bonding and affixing an SAW element requires, subsequent to hardening thereof, a softness which can sufficiently absorb thermal deformation due to seam welding and stress due to contraction during hardening of the adhesive, for example, i.e., a low elastic modulus of under 0.1GPa. However, an elastic conductive adhesive conventionally used to bond and affix an SAW element is obtained by adding typically three kinds of conductive fillers different in shape and dimension, for example, a small particle conductive filler of a particle diameter of 2.2-6.2 µm, a large particle conductive filler of a particle diameter of 8.2-14.3 µm, and a small flaky conductive filler of 2.2-4.4 µm in length, to a silicon type resin material at an appropriate ratio, for example, 22.5/77.5 % by weight. As a result, in a conductive adhesive actually coated on a mounting surface of a base and hardened, these three conductive fillers are unevenly distributed and there is a lot of elastic resin material among the fillers.

Such elastic conductive adhesive, when a bonding wire tip is pressed to a bonding pad surface by the wedge tool, may undergo elastic deformation unnecessarily so that an SAW element may possibly sink heavily. Since the joint state of a bonding wire bonded by the wedge bonding method is determined by the ultrasonic output, the load on the bonding wire, the processing time, and the balance of these, if the SAW element sinks too much, the load on the bonding wire and ultrasonic vibration disappear, thereby creating a problem of making it impossible to get a proper state of joint.

It is an object of this invention to overcome these problems and to provide a conductive adhesive suitable for fixing a piezoelectric element to a base in a piezoelectric device while being capable of fully absorbing stress such as thermal deformation due to seam welding of the piezoelectric device and allowing wire bonding with the proper state of joint. It is another object of this invention to provide a piezoelectric device of high quality and high reliability which, in addition to attaining high frequency and high precision, is able to realize improvement of vibration characteristics and temperature characteristics, by bonding and affixing an SAW element or other piezoelectric element by means of such conductive adhesive, thereby making it possible to enhance bondability in wire bonding, that is, ease of joining.

These objects are achieved by a conductive adhesive as claimed in claims 1 and 2 and a piezoelectric device as claimed in claim 5. Preferred embodiments of the invention are subject-matter of the dependent claims.

According to claim 1, since all the conductive filler is constituted by a flaky conductive filler, in manufacturing a piezoelectric device, upon pressurizing and bonding the piezoelectric element to the conductive adhesive on a mounting surface of a base, flakes of the conductive filler arrange mutually in close proximity to one another piling up in the conductive adhesive after hardening, so that a much smaller amount of the resin material exists between the flakes of the conductive than conventionally. As a result, when pressurizing by the wedge tool from above in subjecting the piezoelectric element to wire bonding, the conductive adhesive after hardening undergoes less elastic deformation, thereby reducing the sinkage of the piezoelectric element to a large extent and enhancing bondability. Consequently, it is possible to connect the bonding wires in the proper state of joint.

According to claim 2, since the conductive filler is composed of two kinds of large and small particulate conductive fillers, likewise, in manufacturing the piezoelectric device, when the piezoelectric element is pressed and bonded to the conductive adhesive on the mounting surface of the adhesive base, the particles of the conductive fillers are evenly distributed with those of the small particulate conductive fillers filling the gaps between adjacent ones of those of large particulate conductive fillers, one on top of another. By this means, the amount of resin material existing between the conductive filler particles becomes smaller than conventionally, so that, when pressurizing by the wedge tool from above in subjecting the piezoelectric element to wire bonding, the conductive adhesive after hardening is able to cause less elastic deformation, while maintaining sufficient softness.

Referring to attached drawings, preferred embodiments of a piezoelectric device and a conductive adhesive according to this invention will be described in detail.
- FIG. 1A: is a plan view showing an embodiment of an SAW device to which this invention is applied,
- FIG. 1 B: is a sectional view along line I―I in FIG. 1A;
- FIG. 2: is a partially enlarged sectional view showing how to carry out wire bonding of a bonding pad of a SAW element;
- FIG. 3A: is an enlarged partial sectional view schematically showing a post-hardening state of a conductive filler in a conductive adhesive of a first embodiment,
- FIG. 3B: is a view same as that in FIG. 3A showing a post-hardening state of a conductive filler in a conductive adhesive of a second embodiment,
- FIG. 3C: is a view same as that in FIG. 3A showing a post-hardening state of a conductive filler in a conventional conductive adhesive;
- FIG. 4: is a schematic diagram showing the results of a heat cycle test of Examples 1 and 2, and the Comparative Example at temperatures from -55°C to 125°C; and
- FIG. 5: is a schematic diagram showing the results of a 150 °C exposure test of Examples 1 and 2, and the Comparative Example.

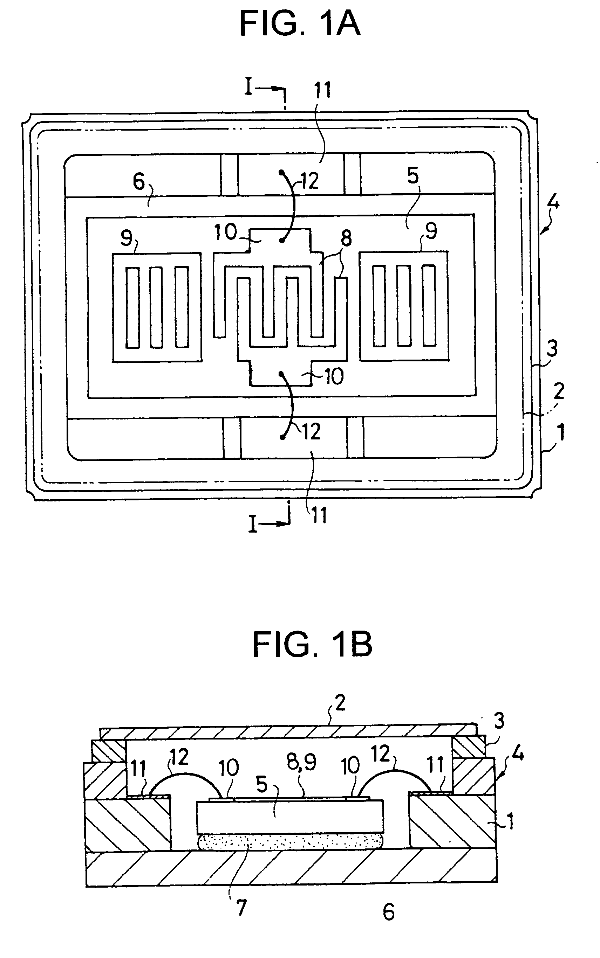

FIGs. 1A and 1B show an embodiment of an SAW device to which this invention is applied. This SAW device has a package 4 composed of a rectangular box-shaped base 1 whose upper part is hermetically closed by a lid 2 of a thin metallic plate. The lid 2 is joined to an upper end of the base 1 by seam welding through a seal ring 3. An SAW element 5 is mounted and sealed in the package 4. The base 1 is a multi-layer structure of a plurality of thin plates of a ceramic material such as alumina. On a mounting surface 6 on the bottom of an empty space inside the base 1, the SAW element 5 is bonded and affixed by a conductive adhesive 7 of this invention. The empty space has a first portion, whose bottom defines the mounting surface 6, and a second portion on either side, in the width direction, of the first portion. The first portion is deeper than the second portions so that steps are formed on both sides of the deeper first portion.

The SAW element 5 has IDTs formed on the center of an upper surface of a rectangular piezoelectric substrate made of a material such as quartz, lithium tantalate, or lithium niobate. The IDTs consist of a pair of inter digital electrodes 8, and a respective grid-like reflector 9 formed on each of both sides in the length direction. Each of the inter digital electrodes 8 has, in continuation with its bus bar, a bonding pad 10 in proximity to the longitudinal periphery of the substrate. The inter digital electrodes, the reflectors, and the bonding pads of this embodiment are formed of aluminum in consideration of its ease of processing and cost. However, it is possible to use other conductive metallic materials such as aluminum alloys which are typically used.

A connection terminal, corresponding to a respective one of the two bonding pads 10, is formed inside the base 1 on an upper surface of each of the two steps mentioned above and, thus, on either side of the SAW element 5 in the width direction. Each connection terminal is electrically connected by a respective bonding wire 12 to the corresponding one of the bonding pads. In this embodiment, to prevent a drop of the joint strength of the bonding wires due to an eutectic, aluminum wires of the same conductive material as the bonding pads are used. The connection terminals are formed, for example, by screen printing of a metallic wiring material such as W or Mo onto a surface of a thin ceramic plate of the base 1 and plating it with Ni or Au. The connection terminals are connected to external terminals on an outer surface of the base 1 through a wiring pattern provided on the thin ceramic plate or a via hole (not illustrated).

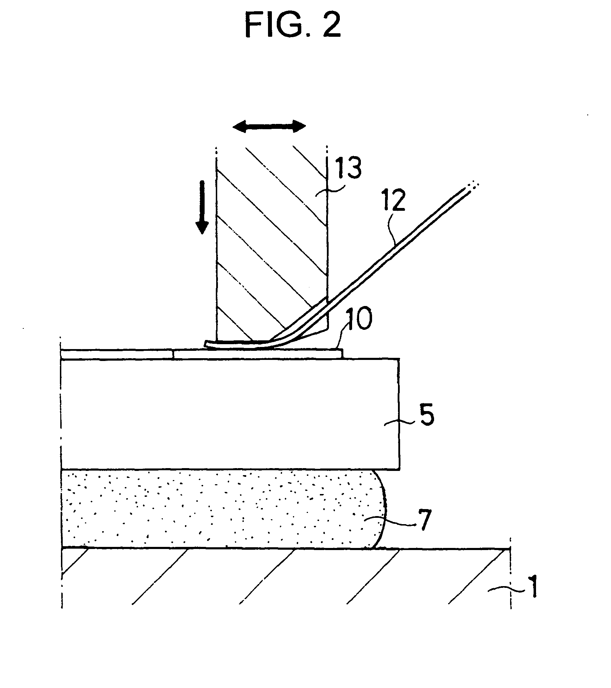

The bonding wires 12 and the bonding pads 10 are connected by means of the wedge bonding method using pressurization and ultrasonic vibration, after an oxide film has been removed from the surface of the bonding pads by mechanical cleaning. As shown in FIG. 2, a tip of a bonding wire 12 is pressed onto the surface of the bonding pad 10 by a prescribed pressure, and then ultrasonic vibration is applied to join the two. After mounting the SAW element 5 and forming a connection in this way, the lid 2 is joined to the seal ring 3 on the upper end of the base 1 by seam welding and the package 4 is hermetically sealed.

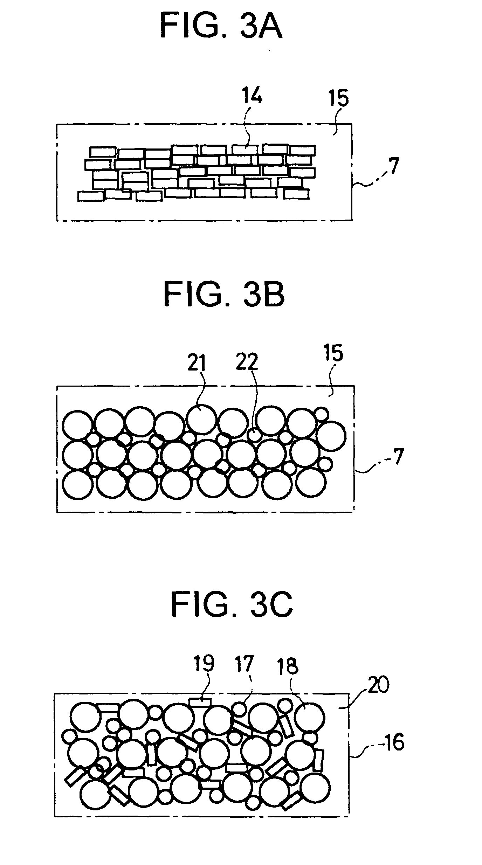

The conductive adhesive 7 according to a first embodiment of this invention is composed of 80 to 85 wt.% of a silicon type resin material and 20 to 15 wt.% of a flaky silver powder as a conductive filler. When the lower surface of the SAW element 5 is pressed, bonded, baked, hardened, and thereby affixed onto the conductive adhesive 7 coated on the mounting surface 6 of the base 1, the flakes of the conductive filler 14 are arranged as shown in FIG. 3A, i.e., side by side and one layer upon the other, with only a small amount of the resin material 15 in between. Consequently, when the SAW element 5 is pressed from above by the wedge tool 13 to carry out wire bonding, the conductive adhesive 7 has little elastic deformation and the SAW element 5 is sufficiently supported to reduce the sinkage to a large extent, thus improving the bondability and keeping the bonding wire to be connected in a proper joint condition at all times. Therefore, it is desirable that the conductive filler 14 contained in the conductive adhesive 7 is comprised of nothing but 100% flaky substance. However, in actuality, shapes other than flakes may be contained; as long as the proportion of flakes is virtually close to 100%, sufficient operation/working-effect of this invention may be obtained.

In this embodiment, the conductive filler consists of a flaky silver powder with flakes being 4.3 to 6.0 µm long, and the hardness of the conductive adhesive after hardening is under 6B and its elastic modulus after hardening is under 0.1GPa.

It has been confirmed that by this means, a very good bondability is obtained in wedge bonding of the bonding wires 12, while, at the same time, even if the base 1 deforms due to thermal expansion generated through the high temperature of seam welding of the lid 2 and the adhesive 7 contracts upon hardening, the resulting stress does not virtually affect the operation of the SAW element 5. Therefore, it is possible for the SAW device of this invention to attain a high frequency and high precision as well as a high quality and high reliability.

On the other hand, FIG. 3C shows a case where a conventional silicon type conductive adhesive 16 is used for bonding and affixing the SAW element 5. This conventional silicon type conductive adhesive 16 is obtained by adding a conductive filler consisting of, for example, a small particulate conductive filler 17 of a particle diameter of 2.2 to 6.2 µm, a large particulate conductive filler 18 of a particle diameter of 8.2 to 14.3 µm, and a small flaky conductive filler 19, 2.2 to 4.4 µm long, to a silicon type resin material 20 at a proper ratio, for example, 22.5/77.5 wt.%. Like the case using only a flaky conductive filler, the hardness of the conductive adhesive 16 after hardening is under 6B and its elastic modulus after hardening is under 0.1GPa.

In this manner, three kinds of conductive filler having different shapes and dimensions are added, and if the content of the resin material increases, the three kinds of conductive filler are distributed unevenly in a layer of the conductive adhesive 16 and much of the silicon type resin material exists between the conductive fillers. Consequently, when pressure is applied to the bonding pad surface with the wedge tool, the conductive adhesive 16 undergoes substantial elastic deformation to cause the SAW element to sink heavily, thus making it impossible to obtain proper joint condition.

The conductive adhesive 7 according to a second embodiment of this invention contains 82.5 to 80 wt.% of a resin material and 17.5 to 15 wt.% of a conductive filler. The conductive filler comprises 30 wt.% of a small particulate conductive filler and 70 wt.% of a large particulate conductive filler. When the lower surface of the SAW element 5 is pressed, bonded, baked, hardened, and affixed onto the conductive adhesive 7 coated on the mounting surface 6 of the base 1, the particles of the conductive fillers are arranged as shown in FIG. 3B, i.e., in a layer of the conductive adhesive 7, the conductive filler particles are piled up one on top of another in a condition in which particles of the small particulate filler 22 are evenly distributed filling the spaces between particles of the large particulate conductive filler 21, so that the amount of the resin material 15 in between these particles is considerably smaller as compared to the conventional case.

Consequently, when the SAW element 5 is pressed from above by the wedge tool 13 to carry out wire bonding, the conductive adhesive 7 has small elastic deformation and the SAW element 5 is sufficiently supported to reduce the sinkage to a large extent, thus improving the bondability and keeping the bonding wire to be connected in a proper joint condition at all times. In comparison with the conductive adhesive of the first embodiment, there are larger gaps between the particles of the conductive fillers such that a greater amount of resin material 15 exists therein, thus enabling sufficient softness to be secured. Consequently, the conductive adhesive 7 is able to absorb any impact from outside such as stress and a drop due to package deformation, adhesive contraction and the like, thus making it possible to secure proper operation and desired characteristics of the SAW element 5. It was found out that especially, if the small particulate conductive filler 21 was a silver powder of a particle diameter of 2.2 to 6.2 µm and if the large particulate conductive filler 22 was a silver powder of a particle diameter of 8.2 to 14.3 µm, it was possible to obtain especially good bondability and softness.

The invention is not limited to the above-mentioned embodiments. For example, various known materials other than silver powder may be used for the conductive filler of the conductive adhesive. Further, in regard to various piezoelectric devices having packages mounted with other piezoelectric elements than a SAW element, or tuning fork type or other piezoelectric vibrating reeds, the same may be applicable.

### Examples

There were respectively manufactured, as Example 1, an SAW resonator having an SAW element bonded and affixed to the base 1 by using the conductive adhesive of the first embodiment of this invention mentioned above in connection with FIG. 3A, and, as Example 2, an SAW resonator having an SAW element bonded and affixed to the base 1 by using the conductive adhesive of the second embodiment of this invention mentioned above in connection with FIG. 3B. A die attachment condition or pressurizing force when bonding the SAW element to the mounting surface of the base was 20 ± 15 g/cm² (1.961 ± 1.471 kPa) for both cases, and the conductive adhesive was hardened by baking in an N₂ atmosphere at 180°C for 1 hour (Example 1), and by baking in vacuum at 280°C for 3 hours (Example 2). For the bonding wires, an Al/Si 1% wire (99% Al, 1% Si) of 40µm diameter was used, and a commercially available full automatic ultrasonic wedge bonder was used to carry out wedge bonding at a processing time of 20 ms, an ultrasonic output of 150 W, and a pressurizing force of 50g. As a Comparison Example, there was manufactured an SAW resonator having the same structure as Examples 1 and 2 but using a conventional silicon type conductive adhesive as explained in connection with FIG. 3C.

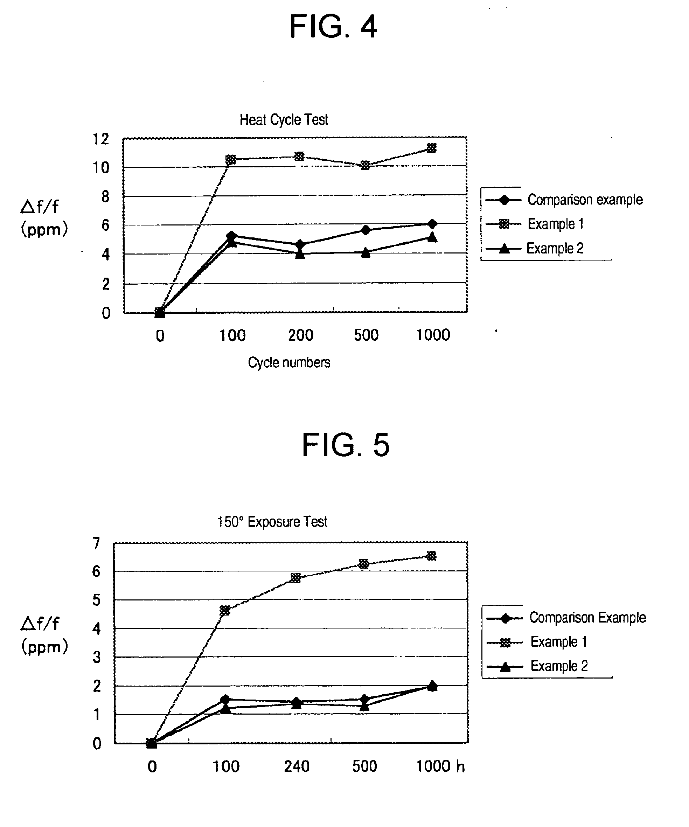

A heat cycle test was conducted on these SAW resonators through repetitions of low temperature (-55°C) and high temperature (125°C) for 30 minutes each and the relative frequency change Δf/f (ppm) of each SAW resonator was measured to test the durability (f is the rated frequency and Δf is the frequency change). The results are shown in FIG. 4. The SAW resonator of Example 1 had a larger frequency change than the comparison example, and the change was substantially constant even when the repetitions of low temperature and high temperature were conducted through 1,000 cycles. The SAW resonator of this Example 2 showed substantially the same frequency change as the comparison example.

Next, a test was conducted for letting the SAW resonators stand at 150°C for 1,000 hours, and the relative frequency change Δf/f (ppm) of each SAW resonator as a function of time was measured to test the durability. The results are shown in FIG. 5. The SAW resonator of Example 1 had a larger frequency change than the comparison example, and this change increased little by little with time. The SAW resonator of Example 2 showed substantially the same frequency change as the comparison example, and both increased slightly after more than 500 hours.

From these test results, it is inferred that the SAW resonator of Example 1, despite its conductive adhesive being harder than that of Example 2 and the comparison example, at the same time, showed excellent stability with respect to temperature change. The SAW resonator of Example 2 showed substantially the same temperature characteristics as the comparison example and it was confirmed to possess sufficient softness.

Further, the joint condition of the bonding wires was evaluated in terms of its joint strength. For the joint strength, a wire tensile test was employed and a bonding pull strength and breakdown mode were measured. The breakdown mode designates, depending on a breakdown section of a wire, A for interface exfoliation from the connection terminal, B for cutting immediately next to the joint section with the connection terminal, C for cutting at the wire pull position, D for cutting immediately next to the joint section with the SAW element bonding pad, and E for interface exfoliation from the bonding pad. The results are shown in the Table below.

**Table**

| | Comparison Example | | Example 1 | | Example 2 | |
|---|---|---|---|---|---|---|
| | Pull strength [g] | Breakdown mode | Pull strength [g] | Breakdown mode | Pull strength [g] | Breakdown mode |
| 1 | 7 | E | 24 | B | 21 | D |
| 2 | 9 | E | 25 | D | 24 | B |
| 3 | 11 | E | 27 | B | 25 | B |
| 4 | 5 | E | 26 | B | 24 | B |
| 5 | 12 | E | 25 | D | 26 | D |
| 6 | 13 | E | 24 | B | 25 | B |
| 7 | 10 | E | 25 | B | 23 | B |
| 8 | 9 | E | 24 | B | 24 | B |
| 9 | 4 | E | 25 | D | 23 | B |
| 10 | 6 | E | 27 | B | 27 | B |
| 11 | 14 | E | 26 | B | 25 | B |
| 12 | 13 | E | 25 | B | 24 | B |
| 13 | 8 | E | 25 | B | 28 | D |
| 14 | 14 | E | 27 | B | 24 | B |
| 15 | 13 | E | 23 | D | 26 | B |
| 16 | 11 | E | 26 | B | 25 | D |
| 17 | 6 | E | 25 | B | 24 | B |
| 18 | 9 | E | 26 | B | 26 | B |
| 19 | 5 | E | 24 | D | 21 | D |
| 20 | 12 | E | 25 | B | 24 | B |
| Average | 9.55 | | 25.2 | | 24.45 | |
| Standard Deviation | 3.24 | | 1.11 | | 1.73 | |

In Examples 1 and 2, a pull strength of more than double that of the comparison example is obtained on average and the breakdown mode is B or D. On the other hand, in the comparison example, the pull strength is not only less than half that of Examples 1 and 2, but its breakdown mode is always E. From this, it follows that by employing the conductive adhesive of this invention, a sufficient joint strength is obtained for the bonding wire and that joining is properly performed.

## Claims

1. A conductive adhesive containing 80 to 85 %by weight of a resin material (15) and 20 to 15 % by weight of a conductive filler (14), wherein the conductive filler is composed of a flaky conductive filler.

2. The conductive adhesive according to claim 1, wherein the conductive filler (14) is a flaky silver powder whose flakes are 4.3 to 6.0 µm long.

3. A conductive adhesive containing 82.5 to 85 % by weight of a resin material (15) and 17.5 to 15 % by weight of a conductive filler (21, 22), the conductive filler consisting essentially of 30 % by weight of a small particulate conductive filler (22) and 70 % by weight of a large particulate conductive filler (21).

4. The conductive adhesive according to claim 3, wherein the small particulate conductive filler (22) is a particulate silver powder of 2.2 to 6.2 µm in particle diameter, and the large particulate conductive filler (21) is a particulate silver powder of 8.2 to 14.3 µm in particle diameter.

5. A piezoelectric device comprising a piezoelectric element (5) and a package (4) housing the piezoelectric element (5), wherein:
a lower surface of the piezoelectric element (5) is bonded and affixed to a mounting surface (6) of the package (4) by means of the conductive adhesive (7) according to any one of claims 1 to 4, and bonding pads (10) on an upper surface of the piezoelectric element (5) and connection terminals (11) of the package (4) are connected by bonding wires (12).

6. The piezoelectric device according to claim 5, wherein the package (4) includes a base (1) constituted by a ceramic material having the mounting surface (6) and a lid (2) joined to the base by seam welding in a hermetically sealed state.

7. The piezoelectric device according to claim 5 or 6, wherein the bonding pads (10) of the piezoelectric element (5) and the bonding wires (12) are composed of an aluminum type material.

8. The piezoelectric device according to any of claims 5 to 7, wherein the piezoelectric element (5) is a surface acoustic wave element.
